# EUROPEAN PATENT APPLICATION

(11) **EP 2 818 793 A2**
(43) Date of publication of application: **31.12.2014**
(21) Application number: 14173687.6
(22) Date of filing: 24.06.2014
(51) Int. Cl.: F21S 8/10

(54) **Light-emitting apparatus and vehicle headlamp system**

(30) Priority: 26.06.2013 JP 2013134076
(71) Applicant: Stanley Electric Co., Ltd., Meguro-ku Tokyo 153-8636 (JP)
(72) Inventor: Liang, Ji-Hao, Tokyo, 153-8636 (JP); Koike, Teruo, Tokyo, 153-8636 (JP)
(74) Representative: Wimmer, Hubert

(57) **Abstract**

To provide a technique capable of alleviating the sense of visual discomfort when light distribution areas are switched. A vehicle lamp (20R, 20L) configured to include a light source (22), wherein the light source (22) comprises a plurality of light-emitting units (30) respectively comprising a control terminal (21) for controlling light emission and extinction, arranged along a first direction, and the plurality of light-emitting units (30) increases in a width of a first direction in proportion to a distance away from a predetermined reference position toward both sides along the first direction, with the width of a light-emitting unit (30a) corresponding to the predetermined reference position being the smallest.

## Description

### BACKGROUND OF THE INVENTION

### Field of the Invention

The present invention relates to a technique for controlling the state of irradiation from a vehicle headlamp.

### Description of the Background Art

When driving a vehicle at night, a driver basically checks the area in front of the vehicle by irradiating a high beam from the headlamps, switching to a low beam as necessary, but also often uses the low beam due to the hassle of switching as well as the road environment. Hence, light is irradiated on the upper side above a so-called cutoff line, possibly casting glare onto an oncoming vehicle or preceding vehicle (hereinafter referred to as "forward vehicle"). Thus, as disclosed in Japanese Patent No. 4624257 for example, in recent years there have been proposed various light distribution control techniques for detecting the position of the lamps (tail lamps or headlamps) of the forward vehicle using an image obtained by taking an image of the forward vehicle by a camera mounted to the subject vehicle, and controlling the irradiation pattern of the high beam to ensure that the position of the forward vehicle is within a shaded range. According to such techniques, it is possible to suppress the glare cast on the forward vehicle and improve early detection of pedestrians as well as distance visibility.

The light distribution control described above can be achieved using a light source comprising a plurality of light-emitting devices (LEDs), individually turning on and off the respective light-emitting device, and enlarging and projecting the light emitted from this light source by a projection lens, for example. According to this configuration, it is possible to perform control that turns off the light-emitting devices corresponding to the light distribution areas that are to preferably serve as the shaded range and turns on the other light-emitting devices, thereby relatively easily achieving the light distribution control described above.

However, in the prior art light source, the chip sizes of the respective light-emitting devices are identical and the light-emitting devices are arranged at equal intervals, causing the widths of the light distribution areas obtained by projecting the light emitted from the respective light-emitting devices to be identical and arranged at equal intervals as well.

In such a case, if the number of light-emitting devices capable of controlling the lighting is decreased in view of the cost of the control apparatus and the like, for example, the widths of the respective light distribution areas relatively increase. As a result, when the light distribution areas to be turned on are switched in accordance with a change in the position of the forward vehicle, the movement of the light is not always visually smooth, causing a sense of discomfort in the driver and others.

### SUMMARY OF THE INVENTION

It is therefore an object of the specific aspects according to the present invention to provide a technique capable of alleviating the sense of visual discomfort when light distribution areas are switched.

The vehicle lamp of an aspect according to the present invention is a vehicle lamp configured to include a light source, wherein: (a) the light source comprises a plurality of light-emitting units respectively comprising a control terminal for controlling light emission and extinction, arranged along a first direction, and (b) the plurality of light-emitting units increases in a width of a first direction in proportion to a distance away from a predetermined reference position toward both sides along the first direction, with the width of a light-emitting unit corresponding to the predetermined reference position being the smallest.

According to the above-stated configuration, the plurality of light-emitting units decreases in width in proportion to the distance near and increases in width in proportion to the distance away from the reference position, making it possible to set light distribution areas that are narrower near the center area in front of the subject vehicle during light distribution control by installing the vehicle lamps on the vehicle so that the light emitted from these light-emitting units is projected in front of the subject vehicle by a lens or the like. As a result, there is a decrease in the visual light movement when the light distribution areas near the center area in front of the subject vehicle where the viewing frequency of the driver and others is relatively high are switched, making it possible to alleviate the sense of discomfort of the driver and others.

In the vehicle lamp described above, the respective widths of the plurality of light-emitting units is preferably set so as to increase in proportion to the distance away from the reference position at equal ratio intervals.

In the vehicle lamp described above, the light source preferably comprises a common electrode, a plurality of individual electrodes, and a light-emitting layer disposed between the common electrode and the plurality of individual electrodes, and the respective areas corresponding to the plurality of individual electrodes are preferably equivalent to the plurality of light-emitting units as well.

In the vehicle lamp described above, the respective widths of the plurality of individual electrodes preferably correspond to the respective widths of the first direction of the plurality of light-emitting units.

The vehicle headlamp system of an aspect according to the present invention is a vehicle headlamp system configured to include any of the vehicle lamps described above and a lighting control apparatus that controls this vehicle lamp.

According to the above-stated configuration, there is a decrease in the visual light movement when the light distribution areas near the center area in front of the subject vehicle where the viewing frequency of the driver and others is relatively high are switched, making it possible to alleviate the sense of discomfort of the driver and others.

### BRIEF DESCRIPTION OF THE DRAWINGS

Fig. 1 is a block diagram showing the configuration of a vehicle headlamp system of an embodiment.
Fig. 2 is a schematic diagram showing the optical configuration of the lamp unit.
Fig. 3A is a plan view schematically showing the structure of the LED light source.
Fig. 3B is a cross-sectional view schematically showing the structure of the LED light source.
Fig. 4A is a schematic plan view showing an embodiment of the light-emitting units of the LED light source.
Fig. 4B is a schematic plan view showing another embodiment of the light-emitting units of the LED light source.
Fig. 4C is a schematic plan view showing a comparison example of the light-emitting units of the LED light source.

### DESCRIPTION OF THE PREFERRED EMBODIMENTS

Now, an embodiment of the present invention will be described below with reference to the accompanying drawings.

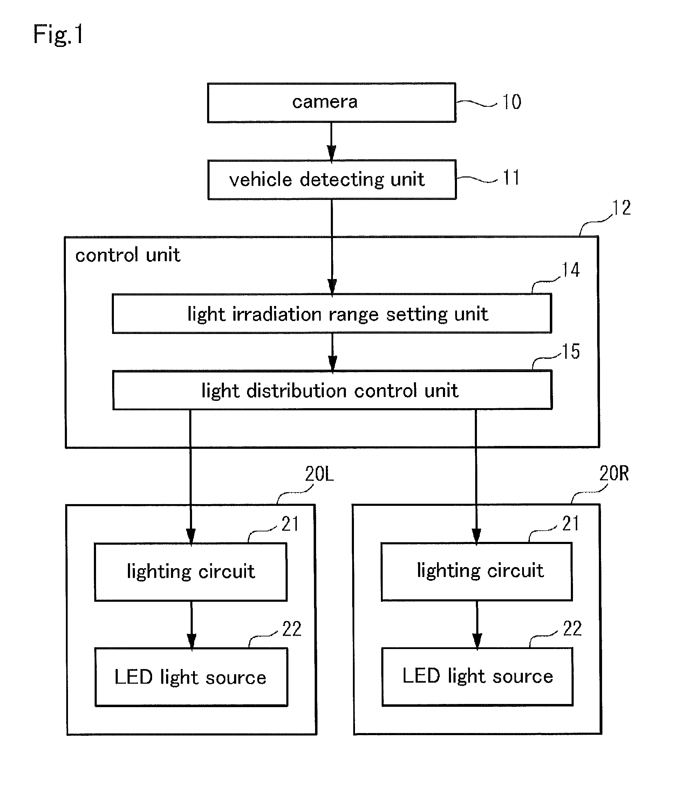

Fig. 1 is a block diagram showing the configuration of a vehicle headlamp system of an embodiment. The vehicle headlamp system shown in Fig. 1 sets a light distribution pattern based on an image obtained by taking an image of the space in front of the subject vehicle (target space) and irradiates light, and is configured to include a camera 10, a vehicle detecting unit 11, a control unit 12, and a pair of lamp units (vehicle lamps) 20R and 20L.

The camera 10 is installed in a predetermined position of the subject vehicle (near the inner rearview mirror, for example), takes an image of the space in front of the vehicle, and outputs the image (image data).

The vehicle detecting unit 11 detects the position of the forward vehicle by performing predetermined image processing using the image data output from the camera 10, and outputs the position information to the control unit 12. The term "forward vehicle" here refers to a preceding vehicle or an oncoming vehicle. This vehicle detecting unit 11 is achieved by executing a predetermined operation program in a computer system comprising a CPU, ROM, RAM, and the like, for example. The vehicle detecting unit 11 is integrally configured with the camera 10, for example. Note that the function of the vehicle detecting unit 11 may be achieved in the control unit 12.

The control unit 12 is achieved by executing a predetermined operation program in a computer system comprising a CPU, ROM, RAM, and the like, for example, and comprises a light irradiation range setting unit 14 and a light distribution control unit 15 as function blocks.

The light irradiation range setting unit 14 sets the light irradiation range corresponding to the position of the forward vehicle detected by the vehicle detecting unit 11. Specifically, the light irradiation range setting unit 14 sets the area where the forward vehicle exists as a light non-irradiation range, and all other areas as the light irradiation range.

The light distribution control unit 15 generates a light distribution control signal corresponding to the light distribution pattern based on the light irradiation range and non-irradiation range set by the light irradiation range setting unit 14, and outputs the light distribution control signal to the respective lamp units 20R and 20L.

The lamp unit 20R is installed on the front right side of the subject vehicle, and is used to irradiate light that illuminates the area in front of the vehicle, and comprises a lighting circuit 21 and an LED light source 22. Similarly, the lamp unit 20L is installed on the front left side of the subject vehicle, and is used to irradiate light that illuminates the area in front of the vehicle, and comprises the lighting circuit 21 and the LED light source 22.

The lighting circuit 21 selectively turns on the respective LEDs by supplying a drive signal to the plurality of LEDs (light-emitting diodes) included in the LED light source 22, based on the control signal output from the light distribution control unit 15.

The LED light source 22 comprises a plurality of LEDs, and each of the plurality of LEDs is selectively turned on based on the drive signal supplied from the lighting circuit 21. This LED light source 22 is capable of individually turning on each of the plurality of LEDs and controlling the light intensity (brightness) thereof.

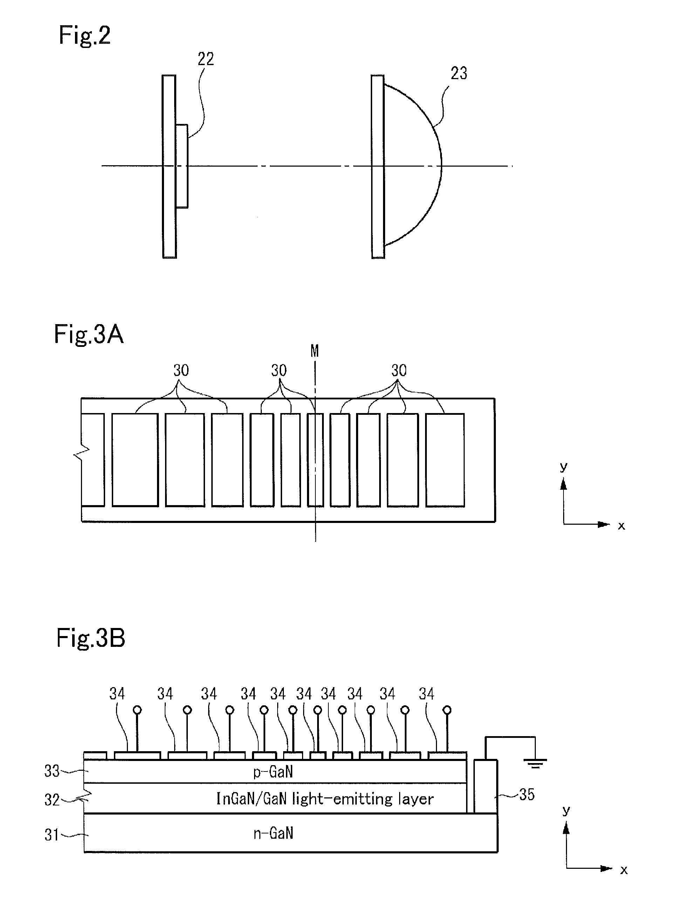

Fig. 2 is a schematic diagram showing the optical configuration of the lamp unit. As shown in Fig. 2, the lamp unit 20R (or 20L) comprises the LED light source 22 described above and a lens (projection lens) 23 disposed on the front surface thereof, and the light emitted from the LED light source 22 is projected frontward by the lens 23, thereby forming a beam such as a high beam, a low beam or an irradiation area control beam (ADB: Adaptive Driving Beam) of the light emission area.

Fig. 3A is a plan view schematically showing the structure of the LED light source. As shown in Fig. 3A, the LED light source 22 comprises a plurality of light-emitting units 30 arranged in direction x (the left-right direction in the figure in this example). The respective light-emitting units 30 are separated from each other with spaces therebetween. Further, the respective light-emitting units 30 increase in width (length in the direction x) in proportion to the distance away from a predetermined reference position M. In this example, the widths of the respective light-emitting units 30 are set so as to increase in proportion to the distance away from the reference position M at equal ratio intervals. In this example, the lengths in direction y (the up-down direction in the figure in this example) of the respective light-emitting units 30 are the same for every light-emitting unit 30.

Fig. 3B is a cross-sectional view schematically showing the structure of the LED light source. As shown in the figure, the LED light source 22 comprises an n-type GaN layer 31, an InGaN/GaN light-emitting layer 32 layered on the upper side thereof, a p-type GaN layer 33 layered on the upper side thereof, a plurality of individual electrodes 34 provided on the upper side thereof, and a common electrode 35 connected to the n-type GaN layer 31. The respective individual electrodes 34 of this example are configured by patterning the p-type GaN film. Further, the common electrode 35 is configured by patterning the n-type GaN film. In this example, the widths (length in the direction x) of the respective individual electrodes 34 correspond to the widths of the respective light-emitting units 30 described above. The widths of the respective individual electrodes 34 may be determined when the p-type GaN film is patterned.

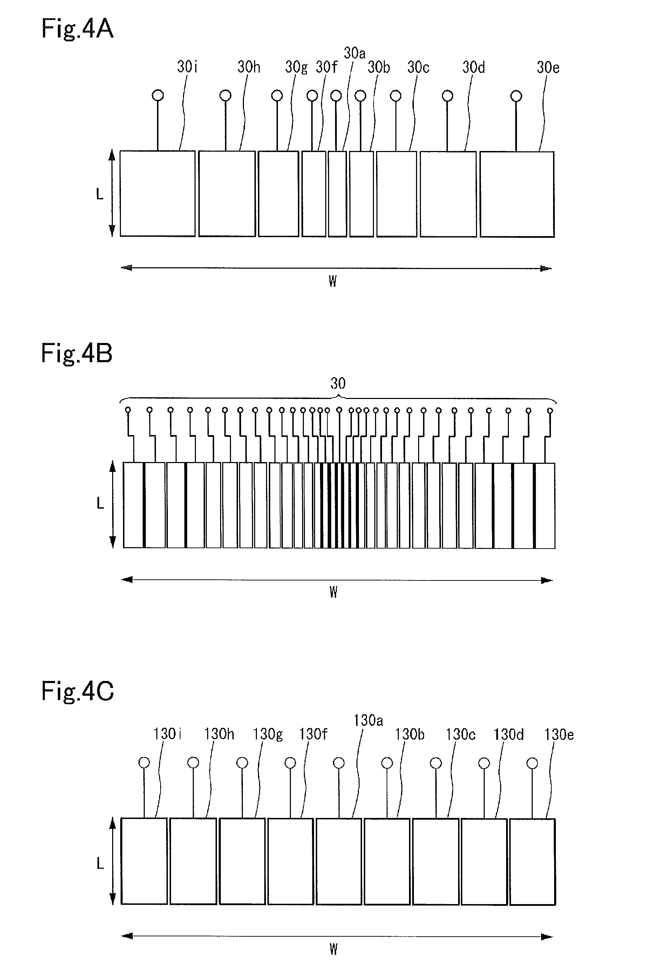

Fig. 4A is a schematic plan view showing an embodiment of the light-emitting units of the LED light source. Fig. 4B is a schematic plan view showing another embodiment of the light-emitting units of the LED light source. Fig. 4C is a schematic plan view showing a comparison example of the light-emitting units of the LED light source.

The LED light source 22 of the embodiment shown in Fig. 4A (hereinafter referred to as "embodiment 1 ") comprises nine light-emitting units 30a-30i, with an overall width W of 4.2 mm and a length L of 0.8 mm. With the position of the light-emitting unit 30a serving as the reference position, the nine light-emitting units 30a and the like increase in width in proportion to the distance away from the light-emitting unit 30a. Specifically, the respective light-emitting units arranged rightward from the light-emitting unit 30a increase in width in the order of the light-emitting unit 30b, the light-emitting unit 30c, the light-emitting unit 30d, and the light-emitting unit 30e. Similarly, the respective light-emitting units arranged leftward from the light-emitting unit 30a increase in width in the order of the light-emitting unit 30f, the light-emitting unit 30g, the light-emitting unit 30h, and the light-emitting unit 30i.

In this embodiment 1 as well, the widths of the respective light-emitting units 30a and the like are set at equal ratio intervals. In embodiment 1, the light-emitting unit 30a with the smallest width is set to a width of 180 µm. With this arrangement, it is possible to set the distant viewing angle when the irradiation and extinction areas (light distribution areas) are provided in the center area in front of the vehicle to 0.22°. In such a case, the minimum irradiation width of the road surface at 100 m in front of the vehicle is 40 cm, and the minimum irradiation adjustment width of the road surface is also 40 cm. Then, the distant viewing angle that is subject to irradiation or extinction increases at an equal ratio from the center area in front of the vehicle toward the side areas. This irradiation/extinction area width is 180 µm for the narrowest light-emitting unit 30a, and 460 µm for each of the widest light-emitting units 30e and 30i. In this embodiment 1, the irradiation/extinction area width and the device separation width are equal.

The LED light source of the comparison example shown in Fig. 4C comprises nine light-emitting units 130a-130i, similar to embodiment 1, but the widths of the respective light-emitting units 130a and the like are identically set (at equal intervals). Specifically, the widths of the respective light-emitting units 130a and the like are all set to 460 µm. In such a case, the minimum distant viewing angle is 0.57°, the minimum irradiation width of the road surface at 100 m in front of the vehicle is 100 cm, and the minimum irradiation adjustment width is also 100 cm. In contrast with such a comparison example, the LED light source 22 of embodiment 1 is capable of increasing the spatial resolution of light distribution control in proportion to the distance near the reference position while not increasing but rather keeping as is the number of light-emitting units to be controlled, in other words, the number of individual electrodes to be controlled. This reference position is made to correspond to the center area in front of the subject vehicle, thereby making it possible to alleviate the sense of discomfort when the shaded range is switched during light distribution control of the center area in front of the subject vehicle.

The LED light source 22 of the embodiment shown in Fig. 4B (hereinafter referred to as "embodiment 2") comprises thirty one light-emitting units 30, with an overall width W of 4.2 mm and a length L of 0.8 mm. In this embodiment 2 as well, with the position of the light-emitting unit 30 located in the center area serving as the reference position, the thirty one light-emitting units 30 increase in width in proportion to the distance away from the light-emitting unit 30 located in the center. In comparison with embodiment 1 described above, this embodiment similarly sets the widths of the respective light-emitting units 30 at equal ratio intervals, but sets the widths of the respective light-emitting units 30 smaller. Specifically, the light-emitting unit 30 with the smallest width is set to a width of 40 µm.

When this LED light source 22 is subject to lighting control, the device separation width is not made to match the width of the irradiation/extinction areas, but rather the width of the radiation/extinction areas is set larger. Specifically, similar to embodiment 1 described above, the width of the irradiation/extinction areas is set to 180 µm. In such a case, the distant viewing angle when the irradiation/extinction areas are provided in the center area in front of the vehicle is similarly 0.22°. Then, the minimum irradiation width of the road surface at 100 m in front of the vehicle is 40 cm. However, since the widths of the respective light-emitting units 30 are smaller, the minimum irradiation adjustment width of the road surface is 8 cm, a smaller value. As a result, the spatial resolution of light distribution control is higher compared to embodiment 1, making finer lighting control possible. For example, in a case where the extinction areas are preferably moved from the left to the right, sequential lighting control is performed so that the leftmost light-emitting unit of the extinction areas at a certain point in time is turned on and the rightmost light-emitting unit is turned off. With this arrangement, it is possible to achieve a smoother movement effect in comparison to the comparison example or embodiment 1, and further alleviate the sense of discomfort of the driver and others.

Thus, according to this embodiment, the plurality of light-emitting units decreases in width in proportion to the distance near and increases in width in proportion to the distance away from the reference position, making it possible to set light distribution areas that are narrower near the center area in front of the subject vehicle during light distribution control by installing the vehicle lamps on the vehicle so that the light emitted from these light-emitting units is projected in front of the subject vehicle by a lens or the like. As a result,, there is a decrease in the visual light movement when the light distribution areas near the center area in front of the subject vehicle where the viewing frequency of the driver and others is relatively high are switched, making it possible to alleviate the sense of discomfort of the driver and others.

Note that this invention is not limited to the subject matter of the foregoing embodiments, and can be implemented by being variously modified within the scope of the gist of the present invention. For example, while the position information of a pedestrian and a forward vehicle is obtained by angles in the embodiments described above, the position information may be expressed by two-dimensional coordinates. Further, while the configuration of the LED light source for irradiating the high beam has been described in the embodiments described above, this LED light source may further comprise a configuration for irradiating the low beam.

## Claims

1. A vehicle lamp configured to include a light source, wherein:
the light source comprises a plurality of light-emitting units respectively comprising a control terminal for controlling light emission and extinction, arranged along a first direction, and
the plurality of light-emitting units increases in a width of a first direction in proportion to a distance away from a predetermined reference position toward both sides along the first direction, with the width of a light-emitting unit corresponding to the predetermined reference position being the smallest.

2. A vehicle lamp configured to include a light source, wherein:
the light source comprises a plurality of light-emitting units respectively comprising a control terminal for controlling light emission and extinction, arranged along a first direction,
the plurality of light-emitting units increases in a width of a first direction in proportion to a distance away from a predetermined reference position toward both sides along the first direction, with the width of a light-emitting unit corresponding to the predetermined reference position being the smallest, and
the respective widths of the plurality of light-emitting units is set so as to increase in proportion to the distance away from the reference position at equal ratio intervals.

3. A vehicle lamp configured to include a light source, wherein:
the light source comprises a plurality of light-emitting units respectively comprising a control terminal for controlling light emission and extinction, arranged along a first direction,
the plurality of light-emitting units increases in a width of a first direction in proportion to a distance away from a predetermined reference position toward both sides along the first direction, with the width of a light-emitting unit corresponding to the predetermined reference position being the smallest, and
wherein the light source comprises a common electrode, a plurality of individual electrodes, and a light-emitting layer disposed between the common electrode and the plurality of individual electrodes, and the respective areas corresponding to the plurality of individual electrodes are equivalent to the plurality of light-emitting units.

4. The vehicle lamp according to claim 2,
wherein the light source comprises a common electrode, a plurality of individual electrodes, and a light-emitting layer disposed between the common electrode and the plurality of individual electrodes, and the respective areas corresponding to the plurality of individual electrodes are equivalent to the plurality of light-emitting units.

5. The vehicle lamp according to claim 1,
wherein the respective widths of the plurality of individual electrodes correspond to the respective widths of the first direction of the plurality of light-emitting units.

6. The vehicle lamp according to claim 2,
wherein the respective widths of the plurality of individual electrodes correspond to the respective widths of the first direction of the plurality of light-emitting units.

7. The vehicle lamp according to claim 3,
wherein the respective widths of the plurality of individual electrodes correspond to the respective widths of the first direction of the plurality of light-emitting units.

8. The vehicle lamp according to claim 4,
wherein the respective widths of the plurality of individual electrodes correspond to the respective widths of the first direction of the plurality of light-emitting units.

9. A vehicle headlamp system configured to include the vehicle lamp described in claim 1 and a lighting control apparatus that controls the vehicle lamp.

10. A vehicle headlamp system configured to include the vehicle lamp described in claim 2 and a lighting control apparatus that controls the vehicle lamp.

11. A vehicle headlamp system configured to include the vehicle lamp described in claim 3 and a lighting control apparatus that controls the vehicle lamp.

12. A vehicle headlamp system configured to include the vehicle lamp described in claim 4 and a lighting control apparatus that controls the vehicle lamp.

13. A vehicle headlamp system configured to include the vehicle lamp described in claim 5 and a lighting control apparatus that controls the vehicle lamp.

14. A vehicle headlamp system configured to include the vehicle lamp described in claim 6 and a lighting control apparatus that controls the vehicle lamp.

15. A vehicle headlamp system configured to include the vehicle lamp described in claim 7 and a lighting control apparatus that controls the vehicle lamp.

16. A vehicle headlamp system configured to include the vehicle lamp described in claim 8 and a lighting control apparatus that controls the vehicle lamp.
